# EUROPEAN PATENT APPLICATION

(11) **EP 4 436 081 A1**
(43) Date of publication of application: **25.09.2024**
(21) Application number: 22891707.6
(22) Date of filing: 10.10.2022
(51) Int. Cl.: H04L 5/00

(54) **ANTENNA CALIBRATION METHOD, DEVICE, APPARATUS, AND STORAGE MEDIUM**

(30) Priority: 15.11.2021 CN 202111347743
(71) Applicant: Datang Mobile Communications Equipment Co., Ltd., Beijing 100085 (CN)
(72) Inventor: WANG, Mengjun, Beijing 100085 (CN)
(74) Representative: Studio Torta S.p.A.
(86) International application number: PCT/CN2022/124324
(87) International publication number: WO 2023/082906

(57) **Abstract**

Embodiments of the present disclosure provide an antenna calibration method, a device, an apparatus, and a storage medium. The method is applied to a terminal, and comprises: receiving a calibration resource set sent by a network device, the calibration resource set being used for indicating configuration information associated with a calibration pilot signal; and on the basis of the calibration resource set, receiving a downlink calibration pilot signal and/or sending an uplink calibration pilot signal, so as to assist the network device in completing an antenna calibration process. The embodiments of the present disclosure provide a complete millimeter wave antenna array calibration solution, which comprises determining a primary selection set of an auxiliary calibration terminal, and updating, in the calibration process, the auxiliary calibration terminal and a beam used by the auxiliary calibration terminal; for the calibration process, one or more calibration resource sets may be configured by means of messages such as an RRC, configuration of different types of calibration pilot signals is supported, and the calibration process may be dynamically triggered by means of indication information such as a DCI and an MAC CE, thereby improving the flexibility of antenna calibration.

## Description

### CROSS-REFERENCE TO RELATED APPLICATION

The present application claims priority to Chinese patent application No. 2021113477432 filed on November 15, 2021, entitled "Antenna Calibration Method, Device, Apparatus, and Storage Medium", which is hereby incorporated by reference in its entirety.

### FIELD

The present application relates to the field of radio communication, and in particular to methods and apparatuses for calibrating antennas, devices, and a storage medium.

### BACKGROUND

An array antenna for the 5th generation mobile communication (5G) system works in low frequency, medium frequency or 6 GHz or millimeter wave frequency band. There are many error sources in receiving and transmitting channels. In addition to time-invariant errors led by array processing errors, geometric position installation errors, feeder and distribution network errors, connector consistency errors, etc., when an ambient temperature, time, and/or an operating frequency changes, the phase and gain of an amplifier will change, and mixer characteristic drift, filter delay and amplitude/phase distortion will also lead to time-variant errors in the receiving and transmitting channels. The above errors have a great impact on transmitting and receiving performance of the array antenna, thus performing array antenna calibration is of great practical significance.

At present, in order to calibrate a pilot signal during the operation of a base station and an array antenna, antenna oscillators/antenna channels for calibration are generally added to the antenna array. A common mode includes designing a directional coupler in a microstrip line or in a coaxial line, or designing separate antenna elements as antenna elements/antenna channels for calibration and coupling other antenna elements/antenna channels in the array, to perform transceiver calibration during the operation. This mode requires to add an additional calibration loop to the antenna array, which increases the complexity of antenna array design. Moreover, hybrid beamforming or analog beamforming may be used in a millimeter wave band. In order to ensure forming performance, the antenna array needs to be calibrated during the operation of the system. However, in practical, for a base station millimeter wave band antenna array, it is difficult to perform calibration by additionally adding a calibration loop in an antenna array coupling mode.

### SUMMARY

In order to solve problems in the related art, embodiments of the present application provide methods and apparatuses for calibrating antennas, devices, and a storage medium.

An embodiment of the present application provides a method for calibrating antennas, applied to a terminal, including:
receiving a calibration resource set transmitted from a network device, where the calibration resource set is used to indicate configuration information associated with a calibration pilot signal; and
receiving a downlink calibration pilot signal and/or transmitting an uplink calibration pilot signal based on the calibration resource set, to assist the network device in performing antenna calibration.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the method further includes:
receiving indication information transmitted from the network device, where the indication information is used to indicate the terminal to perform antenna calibration.

In an embodiment, the indication information is first indication information indicating starting or stopping calibration;
receiving the downlink calibration pilot signal and/or transmitting the uplink calibration pilot signal based on the calibration resource set includes:
determining an antenna calibration type based on the calibration resource set; and
receiving the downlink calibration pilot signal and/or transmitting the uplink calibration pilot signal based on the antenna calibration type, the first indication information and the calibration resource set.

In an embodiment, the indication information includes second indication information indicating starting or stopping calibration, and third indication information indicating an antenna calibration type; receiving the downlink calibration pilot signal and/or transmitting the uplink calibration pilot signal based on the calibration resource set includes:
determining the antenna calibration type based on the third indication information; and
receiving the downlink calibration pilot signal and/or transmitting the uplink calibration pilot signal based on the antenna calibration type, the second indication information and the calibration resource set.

In an embodiment, the indication information is fourth indication information indicating starting or stopping antenna calibration of a specified type;
receiving the downlink calibration pilot signal and/or transmitting the uplink calibration pilot signal based on the calibration resource set includes:
receiving the downlink calibration pilot signal and/or transmitting the uplink calibration pilot signal based on the fourth indication information and the calibration resource set.

In an embodiment, the indication information includes one or more of downlink control information (DCI) or media access control control element (MAC CE).

In an embodiment, the calibration pilot signal occupies all subcarriers in a frequency domain where the calibration pilot signal is located.

An embodiment of the present application further provides a method for calibrating antennas, applied to a network device, including:
transmitting a calibration resource set to a terminal, where the calibration resource set is used to indicate configuration information associated with a calibration pilot signal; and
performing antenna calibration based on an uplink calibration pilot signal transmitted from the terminal and/or a measurement result corresponding to a downlink calibration pilot signal.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the method further includes:
transmitting indication information to the terminal, where the indication information is used to indicate the terminal to perform antenna calibration.

In an embodiment, the indication information is first indication information indicating starting or stopping calibration; or,
the indication information includes second indication information indicating starting or stopping calibration, and third indication information indicating an antenna calibration type; or,
the indication information is fourth indication information indicating starting or stopping antenna calibration of a specified type.

In an embodiment, the indication information includes one or more of downlink control information (DCI) or media access control control element (MAC CE).

In an embodiment, the method further includes:
performing a dynamic update for a set of auxiliary calibration terminals based on a signal measurement result reported from the terminals and/or a measurement result obtained by measuring a signal transmitted from the terminal.

An embodiment of the present application further provides a terminal, including a memory, a transceiver and a processor,
where the memory is used to store a computer program, the transceiver is used to transmit and receive data under control of the processor, and the processor is used to read the computer program in the memory and perform the following operations of:
receiving a calibration resource set transmitted from a network device, where the calibration resource set is used to indicate configuration information associated with a calibration pilot signal; and
receiving a downlink calibration pilot signal and/or transmitting an uplink calibration pilot signal based on the calibration resource set, to assist the network device in performing antenna calibration.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the operations further include:
receiving indication information transmitted from the network device, where the indication information is used to indicate the terminal to perform antenna calibration.

In an embodiment, the indication information is first indication information indicating starting or stopping calibration;
receiving the downlink calibration pilot signal and/or transmitting the uplink calibration pilot signal based on the calibration resource set includes:
determining an antenna calibration type based on the calibration resource set; and
receiving the downlink calibration pilot signal and/or transmitting the uplink calibration pilot signal based on the antenna calibration type, the first indication information and the calibration resource set.

In an embodiment, the indication information includes second indication information indicating starting or stopping calibration, and third indication information indicating an antenna calibration type; receiving the downlink calibration pilot signal and/or transmitting the uplink calibration pilot signal based on the calibration resource set includes:
determining the antenna calibration type based on the third indication information; and
receiving the downlink calibration pilot signal and/or transmitting the uplink calibration pilot signal based on the antenna calibration type, the second indication information and the calibration resource set.

In an embodiment, the indication information is fourth indication information indicating starting or stopping antenna calibration of a specified type;
receiving the downlink calibration pilot signal and/or transmitting the uplink calibration pilot signal based on the calibration resource set includes:
receiving the downlink calibration pilot signal and/or transmitting the uplink calibration pilot signal based on the fourth indication information and the calibration resource set.

In an embodiment, the indication information includes one or more of downlink control information (DCI) or media access control control element (MAC CE).

In an embodiment, the calibration pilot signal occupies all subcarriers in a frequency domain where the calibration pilot signal is located.

An embodiment of the present application further provides a network device, including a memory, a transceiver and a processor,
where the memory is used to store a computer program, the transceiver is used to transmit and receive data under control of the processor, and the processor is used to read the computer program in the memory and perform the following operation of:
transmitting a calibration resource set to a terminal, where the calibration resource set is used to indicate configuration information associated with a calibration pilot signal; and
performing antenna calibration based on an uplink calibration pilot signal transmitted from the terminal and/or a measurement result corresponding to a downlink calibration pilot signal.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the operations further include:
transmitting indication information to the terminal, where the indication information is used to indicate the terminal to perform antenna calibration.

In an embodiment, the indication information is first indication information indicating starting or stopping calibration; or,
the indication information includes second indication information indicating starting or stopping calibration, and third indication information indicating an antenna calibration type; or,
the indication information is fourth indication information indicating starting or stopping antenna calibration of a specified type.

In an embodiment, the indication information includes one or more of downlink control information (DCI) or media access control control element (MAC CE).

In an embodiment, the operations further include:
performing a dynamic update for a set of auxiliary calibration terminals based on a signal measurement result reported from the terminals and/or a measurement result obtained by measuring a signal transmitted from the terminal.

An embodiment of the present application further provides an apparatus for calibrating antennas, applied to a terminal, including:
a receiving unit, used for receiving a calibration resource set transmitted from a network device, where the calibration resource set is used to indicate configuration information associated with a calibration pilot signal; and
a first calibrating unit, used for receiving a downlink calibration pilot signal and/or transmitting an uplink calibration pilot signal based on the calibration resource set, to assist the network device in performing antenna calibration.

An embodiment of the present application further provides an apparatus for calibrating antennas, applied to a network device, including:
a transmitting unit, used for transmitting a calibration resource set to a terminal, where the calibration resource set is used to indicate configuration information associated with a calibration pilot signal; and
a second calibrating unit, used for performing antenna calibration based on an uplink calibration pilot signal transmitted from the terminal and/or a measurement result corresponding to a downlink calibration pilot signal.

An embodiment of the present application further provides a computer-readable storage medium storing a computer program, where the computer program is used to cause a computer to perform the steps of the method for calibrating the antenna described above.

An embodiment of the present application further provides a communication device storing a computer program, where the computer program is used to cause the communication device to perform the steps of the method for calibrating the antenna described above.

An embodiment of the present application further provides a processor-readable storage medium storing a computer program, where the computer program is used to cause a processor to perform the steps of the method for calibrating the antenna described above.

An embodiment of the present application further provides a chip product storing a computer program, where the computer program is used to cause the chip product to perform the steps of the method for calibrating the antenna described above.

In the methods and apparatuses for calibrating the antenna, devices, and the storage medium provided by the embodiments of the present application, the calibration resource set is configured to the terminal through the network device, the configuration information associated with the calibration pilot signal is indicated to the terminal, and the terminal may receive the downlink calibration pilot signal and/or transmit the uplink calibration pilot signal based on the configuration information, to assist the network device in performing antenna calibration. There is no need to add an additional calibration loop to the antenna array, which not only reduces the complexity of antenna array design, but also is applicable for antenna array calibration in a millimeter wave band.

### BRIEF DESCRIPTION OF THE DRAWINGS

In order to clearly illustrate the solutions disclosed in the embodiments of the present application, the drawings used in the descriptions of the embodiments are briefly described below. The drawings in the following description are only some embodiments of the present application, and other drawings may be obtained based on these drawings without creative effort for those skilled in the art.
FIG. 1 is a first schematic flowchart of a method for calibrating antennas according to an embodiment of the present application;
FIG. 2 is a second schematic flowchart of a method for calibrating antennas according to an embodiment of the present application;
FIG. 3 is an overall schematic flowchart of a network device performing antenna calibration according to an embodiment of the present application;
FIG. 4 is a schematic flowchart of a network device selecting an auxiliary calibration terminal according to an embodiment of the present application;
FIG. 5 is a schematic flowchart of a network device updating a set of auxiliary calibration terminals according to an embodiment of the present application;
FIG. 6 is a first implementation schematic diagram of a method for calibrating antennas according to an embodiment of the present application;
FIG. 7 is a second implementation schematic diagram of a method for calibrating antennas according to an embodiment of the present application;
FIG. 8 is a third implementation schematic diagram of a method for calibrating antennas according to an embodiment of the present application;
FIG. 9 is a fourth implementation schematic diagram of a method for calibrating antennas according to an embodiment of the present application;
FIG. 10 is a fifth implementation schematic diagram of a method for calibrating antennas according to an embodiment of the present application;
FIG. 11 is a schematic structural diagram of a terminal according to an embodiment of the present application;
FIG. 12 is a schematic structural diagram of a network device according to an embodiment of the present application;
FIG. 13 is a first schematic structural diagram of an apparatus for calibrating antennas according to an embodiment of the present application; and
FIG. 14 is a second schematic structural diagram of an apparatus for calibrating antennas according to an embodiment of the present application.

### DETAILED DESCRIPTION

In the embodiments of the present application, the term "and/or" describes a related relationship of associated objects, and indicates that there may be three kinds of relationships. For example, A and/or B may represent that A exists alone, A and B exist simultaneously, and B exists alone. Character "j" generally indicates that the associated objects have an "or" relationship.

In the embodiments of the present application, the term "multiple" refers to two or more than two, and other quantifiers are similar.

In order to illustrate the objectives, solutions and advantages of the present application clearly, the solutions in the embodiments of the present application are clearly and completely described in the following in conjunction with the accompanying drawings in the present application. These embodiments are a part of the embodiments of the present application, and not all of the embodiments. All other embodiments obtained by a person of ordinary skill in the art based on the embodiments of the present application without creative work are within the scope of the present application.

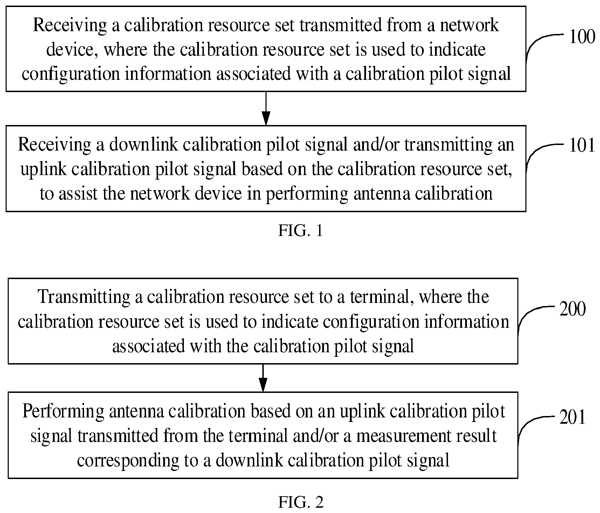

FIG. 1 is a first schematic flowchart of a method for calibrating antennas according to an embodiment of the present application. The method may be applied to a terminal. As shown in FIG. 1, the method includes the following steps.

Step 100: receiving a calibration resource set transmitted from a network device, where the calibration resource set is used to indicate configuration information associated with a calibration pilot signal.

Specifically, an embodiment of the present application provides solutions for calibrating antennas based on a terminal assisting a network device (such as a base station). After selecting a suitable auxiliary calibration terminal, the network device may transmit a calibration resource set to the terminal. The calibration resource set is used to indicate configuration information associated with the calibration pilot signal, and the terminal may receive the calibration resource set transmitted from the network device, and assist the network device in performing antenna calibration based on the configuration information associated with the calibration pilot signal indicated by the calibration resource set.

The calibration resource set may be transmitted to the terminal by the network device through a radio resource control (RRC) message, or may be carried in any other message and transmitted to the terminal, without limitation here.

In an embodiment, the calibration resource set may include one or more of the following:
(1) a calibration resource set for transmission, where the calibration resource set for transmission is used to indicate configuration information associated with a downlink calibration pilot signal;
(2) a calibration resource set for reception, where the calibration resource set for reception is used to indicate configuration information associated with an uplink calibration pilot signal; or,
(3) a calibration resource set for transmission and reception, where the calibration resource set for transmission and reception is used to indicate configuration information associated with the downlink calibration pilot signal and the uplink calibration pilot signal.

In an embodiment, an antenna calibration type may include transmission calibration, reception calibration, transmission-reception calibration and reception-transmission calibration. The transmission calibration may be understood as downlink transmission calibration of the antenna. The transmission calibration requires the network device to transmit the downlink calibration pilot signal. The reception calibration may be understood as uplink reception calibration of the antenna. The reception calibration requires the terminal to transmit the uplink calibration pilot signal. The transmission-reception calibration may be understood as including transmission calibration and reception calibration, where the transmission calibration is performed first and the reception calibration is performed later. The reception-transmission calibration may be understood as including reception calibration and transmission calibration, where the reception calibration is performed first and the transmission calibration is performed later.

The network device configures the calibration resource set for the terminal, and may flexibly configure one or more of the calibration resource set for transmission, the calibration resource set for reception, or the calibration resource set for transmission and reception as required. For example, only the calibration resource set for transmission may be configured for transmission calibration, or only the calibration resource set for reception may be configured for reception calibration, or the calibration resource set for transmission and reception may be configured for transmission-reception calibration or reception-transmission calibration, or both the calibration resource set for transmission and the calibration resource set for reception may be configured simultaneously for transmission-reception calibration or reception-transmission calibration, and so on.

The calibration resource set may directly include the configuration information associated with the calibration pilot signal, or may indicate the configuration information associated with the calibration pilot signal based on existing signaling through implicit indication, or may indicate part of the configuration information explicitly, and indicate the other part of the configuration information implicitly, without specific limitation here.

In an embodiment, the configuration information associated with the calibration pilot signal may include one or more of the following.
(1) A type of the calibration pilot signal. For example, the calibration resource set may indicate that the calibration pilot signal is an uplink calibration pilot signal or a downlink calibration pilot signal. It may also indicate that the uplink calibration pilot signal is a sounding reference signal (SRS) or another pilot signal that may be used for calibration. The calibration resource set may also indicate that the downlink calibration pilot signal is a channel state information-reference signal (CSI-RS), a synchronization signal/PBCH block (SSB) signal or other pilot signals that may be used for calibration.
(2) A frequency domain resource occupied by the calibration pilot signal.
(3) A timing for transmitting the calibration pilot signal.
(4) The number of symbols occupied by the calibration pilot signal.
(5) The number of offset symbols corresponding to the calibration pilot signal, that is, the number of offset symbols of the first symbol among the symbols occupied by the calibration pilot signal from a subframe header corresponding to the first symbol.
(6) A period for transmitting the calibration pilot signal.
(7) A subframe interval for transmitting the calibration pilot signal, that is, a subframe interval for each calibration pilot signal transmission. For example, for transmission calibration, a subframe interval for transmitting the downlink calibration pilot signal by the network device may be indicated.
(8) The number of times for transmitting the calibration pilot signal. It may be understood that the calibration may be performed once or multiple times. Therefore, in a calibration (such as a transmission calibration or a reception calibration), the calibration pilot signal may be transmitted once or multiple times.
(9) A sequence of transmission calibration and reception calibration. For example, when transmission calibration and reception calibration are required to be performed, the network device may indicate whether the transmission calibration or the reception calibration is performed first.

In an embodiment, the calibration pilot signal may occupy all subcarriers in a frequency domain where it is located, to obtain a sufficiently high frequency domain density and improve calibration accuracy.

In an embodiment, the calibration pilot signal does not occupy all subcarriers in the frequency domain where it is located, and may use a calibration pilot signal of a certain pattern, which is more flexible.

Step 101: receiving a downlink calibration pilot signal and/or transmitting an uplink calibration pilot signal based on the calibration resource set, to assist the network device in performing antenna calibration.

In an embodiment, after receiving the calibration resource set transmitted from the network device, the terminal may determine the antenna calibration type based on the configuration information associated with the calibration pilot signal indicated in the calibration resource set, and perform corresponding calibration procedure, such as receiving the downlink calibration pilot signal and/or transmitting the uplink calibration pilot signal, to assist the network device in performing antenna calibration.

For example, after receiving the calibration resource set for transmission transmitted from the network device, the terminal may receive the downlink calibration pilot signal transmitted from the network device based on the configuration information associated with the downlink calibration pilot signal indicated in the calibration resource set for transmission, measure the downlink calibration pilot signal, and then feed back a measurement result to the network device, thereby assisting the network device in performing antenna calibration.

For example, after receiving the calibration resource set for reception transmitted from the network device, the terminal may transmit the uplink calibration pilot signal to the network device based on the configuration information associated with the uplink calibration pilot signal indicated in the calibration resource set for reception, and then the network device may perform antenna calibration based on a measurement result for measuring the uplink calibration pilot signal.

For example, after receiving the calibration resource set for transmission and reception transmitted from the network device, or after receiving the calibration resource set for transmission and the calibration resource set for reception transmitted from the network device simultaneously, the terminal may receive the downlink calibration pilot signal transmitted from the network device and transmit the uplink calibration pilot signal to the network device based on the configuration information associated with the calibration pilot signal indicated in the calibration resource set, to assist the network device in performing transmission calibration and reception calibration for the antenna.

In the method for calibrating the antenna provided by the embodiments of the present application, the calibration resource set is configured to the terminal by the network device, the configuration information associated with the calibration pilot signal is indicated to the terminal, and the terminal receives the downlink calibration pilot signal and/or transmits the uplink calibration pilot signal based on the configuration information, to assist the network device in performing antenna calibration. There is no need to add an additional calibration loop to the antenna array, which not only reduces the complexity of antenna array design, but also is applicable for antenna array calibration in a millimeter wave band.

In an embodiment, the method further includes:
receiving indication information transmitted from the network device, where the indication information is used to indicate the terminal to perform antenna calibration.

In an embodiment, in order to avoid affecting normal operation of a system, existing antenna array calibration generally sets a fixed calibration period, such as 1 hour, 12 hours, etc., which makes it difficult to perform real-time calibration based on service quality requirements.

In solutions for calibrating the antenna based on the terminal assisting the network device provided in the embodiment of the present application, in addition to transmitting the calibration resource set to the terminal, the network device may also transmit the indication information to the terminal, where the indication information is used to indicate the terminal to perform antenna calibration, which enables the antenna calibration to be dynamically triggered as required in real-time. The indication information may be any information capable of dynamic indication, without specific limitation here.

In an embodiment, the indication information includes one or more of downlink control information (DCI) or media access control control element (MAC CE).

In the method for calibrating the antenna provided by the embodiments of the present application, the indication information is transmitted to the terminal through the network device, and the terminal is indicated to perform antenna calibration, which enables the antenna calibration to be dynamically triggered as required, and improves the flexibility of antenna calibration.

In an embodiment, the indication information is first indication information indicating starting or stopping calibration;
receiving the downlink calibration pilot signal and/or transmitting the uplink calibration pilot signal based on the calibration resource set includes:
determining an antenna calibration type based on the calibration resource set; and
receiving the downlink calibration pilot signal and/or transmitting the uplink calibration pilot signal based on the antenna calibration type, the first indication information and the calibration resource set.

In an embodiment, the indication information transmitted from the network device to the terminal may be the first indication information indicating starting or stopping calibration, and the network device may dynamically trigger the terminal to perform antenna calibration as required.

For example, the network device may indicate the terminal to start or stop calibration through the DCI, as shown in table 1. The network device configuring the calibration resource set for transmission and reception for the terminal is taken as an example. If the terminal receives a command for starting calibration from the network device through the DCI, the terminal may first determine that transmission calibration and reception calibration are required (including determining the sequence of transmission calibration and reception calibration) based on the calibration resource set. Then the terminal may start corresponding calibration based on indication of the DCI, receive the downlink calibration pilot signal and transmit the uplink calibration pilot signal, and assist the network device in performing antenna calibration.

**Table 1 Calibration command fields and meanings in DCI**

| Calibration enable | Meaning of command |
|---|---|
| 0 | Start calibration |
| 1 | Stop calibration |

In an embodiment, the indication information includes second indication information indicating starting or stopping calibration, and third indication information indicating an antenna calibration type;
receiving the downlink calibration pilot signal and/or transmitting the uplink calibration pilot signal based on the calibration resource set includes:
determining the antenna calibration type based on the third indication information; and
receiving the downlink calibration pilot signal and/or transmitting the uplink calibration pilot signal based on the antenna calibration type, the second indication information and the calibration resource set.

In an embodiment, the indication information transmitted from the network device to the terminal may include the second indication information indicating starting or stopping calibration and the third indication information indicating the antenna calibration type, and the network device may dynamically trigger the terminal to perform antenna calibration of a specified type as required. Both the second indication information and the third indication information may be any information capable of dynamic indication, without specific limitation here.

For example, the network device may indicate the terminal to start or stop calibration through the DCI, as shown in table 1, and indicate the antenna calibration type through the MAC CE, as shown in table 2. The network device configuring multiple calibration resource sets (including the calibration resource set for transmission, the calibration resource set for reception, and the calibration resource set for transmission and reception) for the terminal is taken as an example. If the terminal receives a command for starting calibration from the network device through the DCI, the terminal may start corresponding calibration based on the antenna calibration type indicated by the MAC CE. For example, when the MAC CE indicates that only transmission calibration is performed, the terminal may start transmission calibration, and receive the downlink calibration pilot signal. Then the terminal may measure the downlink calibration pilot signal, feed back a measurement result to the network device, and assist the network device in performing antenna calibration.

**Table 2 MAC CE calibration type indication**

| Calibration enable | Meaning of command |
|---|---|
| 0 | Transmission calibration |
| 1 | Reception calibration |
| 2 | Transmission calibration and reception calibration |
| 3 | Stop calibration |

In an embodiment, the indication information is fourth indication information indicating starting or stopping antenna calibration of a specified type;
receiving the downlink calibration pilot signal and/or transmitting the uplink calibration pilot signal based on the calibration resource set includes:
receiving the downlink calibration pilot signal and/or transmitting the uplink calibration pilot signal based on the fourth indication information and the calibration resource set.

In an embodiment, the indication information transmitted from the network device to the terminal may be the fourth indication information indicating starting or stopping the antenna calibration of the specified type, and the network device may dynamically trigger the terminal to perform antenna calibration of the specified type as required.

For example, the network device may indicate starting or stopping antenna calibration of the specified type through the MAC CE, as shown in table 3. The network device configuring multiple calibration resource sets (including the calibration resource set for transmission, the calibration resource set for reception, and the calibration resource set for transmission and reception) for the terminal is taken as an example. If the terminal receives a command for starting transmission-reception calibration or reception-transmission calibration from the network device through the MAC CE, the terminal may first determine the sequence of transmission calibration and reception calibration based on the configuration information indicated by the calibration resource set, then start corresponding calibration procedure, receive the downlink calibration pilot signal, transmit the uplink calibration pilot signal, and assist the network device in performing antenna calibration.

**Table 3 MAC CE calibration type indication**

| Calibration enable | Meaning of command |
|---|---|
| 0 | Start transmission calibration |
| 1 | Start reception calibration |
| 2 | Start transmission-reception calibration or reception-transmission calibration |
| 3 | Stop calibration |

In an embodiment, when antenna calibration is required, the network device may first select auxiliary terminals used for calibration based on a signal measurement result reported from the terminal and/or a measurement result of a signal transmitted from the terminal to form a primary set of auxiliary calibration terminals. The primary set of auxiliary calibration terminals may include a primary set of transmission calibration terminals (terminals used for auxiliary antenna transmission calibration), a primary set of reception calibration terminals (terminals used for auxiliary antenna reception calibration) and a primary set of transmission and reception calibration terminals (terminals used for auxiliary antenna transmission calibration and reception calibration).

For example, when transmission calibration is required, the network device may first trigger the terminal to perform downlink signal measurement. After the measurement, the terminal selects an optimal beam and reports a measurement result, such as a CSI-RS resource indicator (CRI), an SSB resource indicator (SSBRI), a reference signal receiving power (RSRP), a reference signal receiving quality (RSRQ), etc. If the network device determines, based on the measurement result reported from the terminal, that a quality of a corresponding signal satisfies a preset threshold, the terminal is added to the primary set of transmission calibration terminals. If the network device determines that the uplink channel and the downlink channel are reciprocal or quasi-reciprocal based on priori information, the terminal may also be added to the primary set of reception calibration terminals.

For example, when reception calibration is required, the network device may first measure the uplink signal (such as SRS signal) transmitted from the terminal, and based on the measurement result, if it is determined that the corresponding signal quality meets the preset threshold, the terminal will be added to the primary set of reception calibration terminals.

In an embodiment, during antenna calibration, the network device may also dynamically update the set of auxiliary calibration terminals based on the signal measurement results reported from the terminals and/or the measurement result of the signal transmitted from the terminals (which may include perform dynamically updating on an analog beam used by the terminal), select a terminal whose signal quality is higher than the preset threshold to continue the auxiliary calibration, and remove a terminal whose signal quality is lower than the preset threshold in the set.

For example, during antenna calibration, the terminal may measure an RSRP or an RSRQ of the downlink calibration pilot signal or the CSI-RS or the SSB signal, and report a measurement result to the network device. The network device may dynamically update a set of auxiliary terminals based on whether the signal quality satisfies the preset threshold.

For example, during the antenna calibration, the network device may measure an RSRP or an RSRQ of the uplink calibration pilot signal or the SRS signal transmitted from the terminal, and dynamically update the set of auxiliary terminals based on whether the signal quality satisfies the preset threshold.

In an embodiment, if the calibration pilot signal conflicts with a scheduling resource, the network device may also dynamically adjust the auxiliary calibration terminal and the analog beam used by the terminal.

Each embodiment of the present application provides a complete millimeter wave antenna array calibration solution, including determining the primary set of auxiliary calibration terminals, and updating the auxiliary calibration terminals and the beams used during calibration. For calibration, RRC or other messages may be used to configure one or more calibration resource sets, configurations of different types of calibration pilot signals are supported, and the DCI, the MAC CE and other indication information may be used to dynamically trigger calibration, which improves the flexibility of antenna calibration.

FIG. 2 is a second schematic flowchart of a method for calibrating antennas according to an embodiment of the present application. The method may be applied to a network device (such as a base station). As shown in FIG. 2, the method includes the following steps.

Step 200: transmitting a calibration resource set to a terminal, where the calibration resource set is used to indicate configuration information associated with the calibration pilot signal.

Specifically, an embodiment of the present application provides solutions for calibrating antennas based on a terminal assisting a network device. After selecting a suitable auxiliary calibration terminal, the network device may transmit a calibration resource set to the terminal. The calibration resource set is used to indicate configuration information associated with the calibration pilot signal, and the terminal may receive the calibration resource set transmitted from the network device, and assist the network device in performing antenna calibration based on the configuration information associated with the calibration pilot signal indicated by the calibration resource set.

In an embodiment, the calibration resource set may include one or more of the following:
(1) a calibration resource set for transmission, where the calibration resource set for transmission is used to indicate configuration information associated with a downlink calibration pilot signal;
(2) a calibration resource set for reception, where the calibration resource set for reception is used to indicate configuration information associated with an uplink calibration pilot signal; or,
(3) a calibration resource set for transmission and reception, where the calibration resource set for transmission and reception is used to indicate configuration information associated with the downlink calibration pilot signal and the uplink calibration pilot signal.

In an embodiment, an antenna calibration type may include transmission calibration, reception calibration, transmission-reception calibration and reception-transmission calibration. The transmission calibration may be understood as downlink transmission calibration of the antenna. The transmission calibration requires the network device to transmit the downlink calibration pilot signal. The reception calibration may be understood as uplink reception calibration of the antenna. The reception calibration requires the terminal to transmit the uplink calibration pilot signal. The transmission-reception calibration may be understood as including transmission calibration and reception calibration, where the transmission calibration is performed first and the reception calibration is performed later. The reception-transmission calibration may be understood as including reception calibration and transmission calibration, where the reception calibration is performed first and the transmission calibration is performed later.

The network device configures the calibration resource set for the terminal, and may flexibly configure one or more of the calibration resource set for transmission, the calibration resource set for reception, or the calibration resource set for transmission and reception as required. For example, only the calibration resource set for transmission may be configured for transmission calibration, or only the calibration resource set for reception may be configured for reception calibration, or the calibration resource set for transmission and reception may be configured for transmission-reception calibration or reception-transmission calibration, or both the calibration resource set for transmission and the calibration resource set for reception may be configured simultaneously for transmission-reception calibration or reception-transmission calibration, and so on.

The calibration resource set may directly include the configuration information associated with the calibration pilot signal, or may indicate the configuration information associated with the calibration pilot signal based on existing signaling through implicit indication, or may indicate part of the configuration information explicitly, and indicate the other part of the configuration information implicitl, without specific limitation here.

In an embodiment, the configuration information associated with the calibration pilot signal may include one or more of the following.
(1) A type of the calibration pilot signal.
(2) A frequency domain resource occupied by the calibration pilot signal.
(3) A timing for transmitting the calibration pilot signal.
(4) The number of symbols occupied by the calibration pilot signal.
(5) The number of offset symbols corresponding to the calibration pilot signal.
(6) A period for transmitting the calibration pilot signal.
(7) A subframe interval for transmitting the calibration pilot signal.
(8) The number of times for transmitting the calibration pilot signal.
(9) A sequence of transmission calibration and reception calibration.

Step 201: performing antenna calibration based on an uplink calibration pilot signal transmitted from the terminal and/or a measurement result corresponding to a downlink calibration pilot signal.

In an embodiment, after receiving the calibration resource set transmitted from the network device, the terminal may determine the antenna calibration type based on the configuration information associated with the calibration pilot signal indicated in the calibration resource set, and perform corresponding calibration procedure, such as receiving the downlink calibration pilot signal and/or transmitting the uplink calibration pilot signal. The network device may then perform antenna calibration based on the uplink calibration pilot signal transmitted from the terminal and/or the measurement result corresponding to the downlink calibration pilot signal.

For example, after receiving the calibration resource set for transmission transmitted from the network device, the terminal may receive the downlink calibration pilot signal transmitted from the network device based on the configuration information associated with the downlink calibration pilot signal indicated in the calibration resource set for transmission, measure the downlink calibration pilot signal, and then feed back a measurement result to the network device. The network device may then determine an antenna calibration parameter based on the measurement result corresponding to the downlink calibration pilot signal transmitted from the terminal, and perform antenna calibration.

For example, after receiving the calibration resource set for reception transmitted from the network device, the terminal may transmit the uplink calibration pilot signal to the network device based on the configuration information associated with the uplink calibration pilot signal indicated in the calibration resource set for reception. The network device may then determine an antenna calibration parameter by measuring the uplink calibration pilot signal, and perform antenna calibration.

In the method for calibrating the antenna provided by the embodiments of the present application, the calibration resource set is configured to the terminal by the network device, the configuration information associated with the calibration pilot signal is indicated to the terminal, and the terminal receives the downlink calibration pilot signal and/or transmits the uplink calibration pilot signal based on the configuration information, to assist the network device in performing antenna calibration. There is no need to add an additional calibration loop to the antenna array, which not only reduces the complexity of antenna array design, but also is applicable for antenna array calibration in a millimeter wave band.

In an embodiment, the method further includes:
transmitting indication information to the terminal, where the indication information is used to indicate the terminal to perform antenna calibration.

In an embodiment, in order to avoid affecting normal operation of a system, existing antenna array calibration generally sets a fixed calibration period, such as 1 hour, 12 hours, etc., which makes it difficult to perform real-time calibration based on service quality requirements.

In solutions for calibrating the antenna based on the terminal assisting the network device provided in the embodiment of the present application, in addition to transmitting the calibration resource set to the terminal, the network device may also transmit the indication information to the terminal, where the indication information is used to indicate the terminal to perform antenna calibration, which enables the antenna calibration to be dynamically triggered as required in real-time. The indication information may be any information capable of dynamic indication, without specific limitation here.

In an embodiment, the indication information includes one or more of downlink control information (DCI) or media access control control element (MAC CE).

In an embodiment, the indication information may be first indication information indicating starting or stopping calibration. For example, the network device may indicate to start or stop calibration through the DCI, or may indicate to start or stop calibration through the MAC CE.

In an embodiment, the indication information may include second indication information indicating starting or stopping calibration and third indication information indicating an antenna calibration type. For example, the network device may indicate to start or stop calibration through the DCI, and indicate the antenna calibration type through the MAC CE.

In an embodiment, the indication information may be fourth indication information indicating starting or stopping antenna calibration of a specified type. For example, the network device may indicate to start or stop antenna calibration of the specified type through the DCI, or may indicate to start or stop antenna calibration of the specified type through the MAC CE.

In the method for calibrating the antenna provided by the embodiments of the present application, the indication information is transmitted to the terminal from the network device, and the terminal is indicated to perform antenna calibration, which enables the antenna calibration to be dynamically triggered as required, and improves the flexibility of antenna calibration.

In an embodiment, the method further includes:
performing a dynamic update for a set of auxiliary calibration terminals based on a signal measurement result reported from the terminals and/or a measurement result obtained by measuring a signal transmitted from the terminal.

In an embodiment, during antenna calibration, the network device may dynamically update the set of auxiliary calibration terminals based on the signal measurement results reported from the terminals and/or the measurement result of the signal transmitted from the terminals (which may include perform dynamically updating on an analog beam used by the terminal), select a terminal whose signal quality is higher than the preset threshold to continue the auxiliary calibration, and remove a terminal whose signal quality is lower than the preset threshold in the set.

For example, during antenna calibration, the terminal may measure an RSRP or an RSRQ of the downlink calibration pilot signal or the CSI-RS or the SSB signal, and report a measurement result to the network device. The network device may dynamically update a set of auxiliary terminals based on whether the signal quality satisfies the preset threshold.

For example, during the antenna calibration, the network device may measure an RSRP or an RSRQ of the uplink calibration pilot signal or the SRS signal transmitted from the terminal, and dynamically update the set of auxiliary terminals based on whether the signal quality satisfies the preset threshold.

In an embodiment, if the calibration pilot signal conflicts with a scheduling resource, the network device may also dynamically adjust the auxiliary calibration terminal and the analog beam used by the terminal.

Each embodiment of the present application provides a complete millimeter wave antenna array calibration solution, including determining the primary set of auxiliary calibration terminals, and dynamically updating the auxiliary calibration terminals and the beams used during calibration. For calibration, RRC or other messages may be used to configure one or more calibration resource sets, configurations of different types of calibration pilot signals are supported, and the DCI, the MAC CE and other indication information may be used to dynamically trigger calibration, which improves the flexibility of antenna calibration.

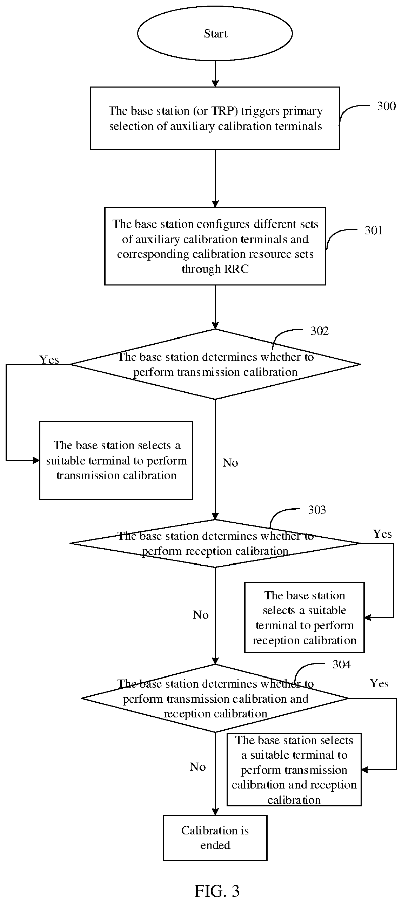

FIG. 3 is an overall schematic flowchart of a network device performing antenna calibration according to an embodiment of the present application. As shown in FIG. 3, the network device being a base station or a network side transmitting receiving point (TRP) is taken as an example. The flowchart mainly includes the following steps.

Step 300: the base station (or TRP, for ease of description, subsequent embodiments will take the network device being a base station as an example) triggers primary selection of auxiliary calibration terminals.

Step 301: the base station configures different sets of auxiliary calibration terminals and corresponding calibration resource sets through RRC, such as a calibration resource set for transmission, a calibration resource set for reception, or a calibration resource set for transmission and reception.

Step 302: the base station determines whether to perform transmission calibration. If transmission calibration is needed, the base station selects a suitable terminal to perform transmission calibration; otherwise, step 303 is performed.

Step 303: the base station determines whether to perform reception calibration. If reception calibration is needed, the base station selects a suitable terminal to perform reception calibration; otherwise, step 304 is performed.

Step 304: the base station determines whether to perform transmission calibration and reception calibration. If transmission calibration and reception calibration are needed, the base station selects a suitable terminal to perform transmission calibration and reception calibration; otherwise, calibration is ended.

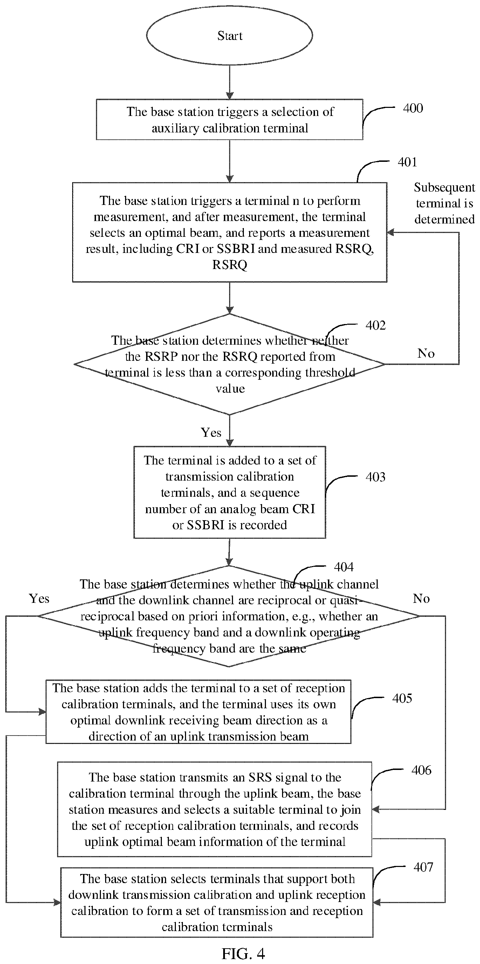

FIG. 4 is a schematic flowchart of a network device selecting an auxiliary calibration terminal according to an embodiment of the present application. As shown in FIG. 4, the flowchart mainly includes the following steps.

Step 400: the base station triggers a selection of auxiliary calibration terminal.

Step 401: the base station triggers a terminal n to perform measurement. After measurement, the terminal n selects an optimal beam, and reports a measurement result, including CRI or SSBRI and measured RSRQ, RSRQ, etc.

Step 402: the base station determines whether neither the RSRP nor the RSRQ reported from the terminal n is less than a corresponding threshold value. If yes, step 403 is performed; otherwise, terminal n is not added to a set of transmission calibration terminals, and other subsequent terminals are continued to be determined.

Step 403: the base station adds the terminal n to the set of transmission calibration terminals S-tx-cal, and records a sequence number of an analog beam CRI or SSBRI.

Step 404: the base station determines whether the uplink channel and the downlink channel are reciprocal or quasi-reciprocal based on priori information. For example, the base station may determine based on whether an uplink frequency band and a downlink frequency band are the same. If yes, step 405 is performed; otherwise, step 406 is performed.

Step 405: the base station adds terminal n to a set of reception calibration terminals S-rx-cal, and the terminal n uses its own optimal downlink receiving beam direction as a direction of an uplink transmission beam.

Step 406: the base station triggers uplink beam calibration, the terminal transmits an SRS signal. The base station measures the SRS signal, selects a suitable terminal, and adds the terminal to the set of reception calibration terminals S-rx-cal, and records uplink optimal beam information of the terminal.

Step 407: the base station selects terminals that support both downlink transmission calibration and uplink reception calibration to form a set of transmission and reception calibration terminals S-tx-rx-cal.

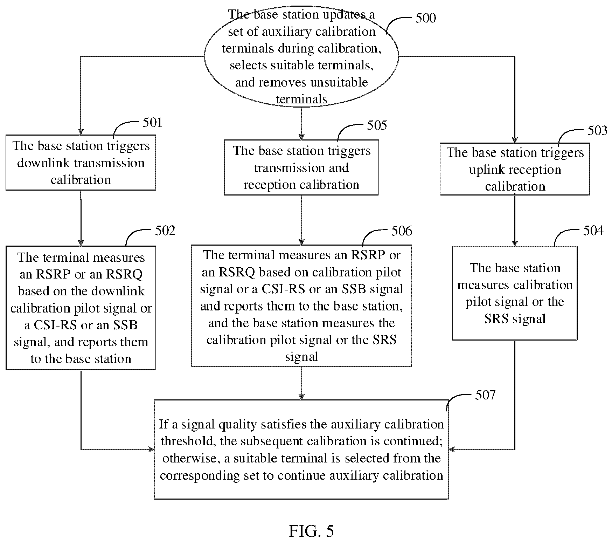

FIG. 5 is a schematic flowchart of a network device updating a set of auxiliary calibration terminals according to an embodiment of the present application. As shown in FIG. 5, the flowchart mainly includes the following steps.

Step 500: the base station updates a set of auxiliary calibration terminals during calibration, selects suitable terminals, and removes unsuitable terminals.

Step 501: the base station triggers downlink transmission calibration and transmits a downlink calibration pilot signal to the terminal.

Step 502: the terminal measures an RSRP or an RSRQ based on the downlink calibration pilot signal or a CSI-RS or an SSB signal, and reports them to the base station.

Step 503: the base station triggers uplink reception calibration, and the terminal transmits an uplink calibration pilot signal to the base station.

Step 504: the base station measures the uplink calibration pilot signal or the SRS signal.

Step 505: the base station triggers transmission calibration and reception calibration. The base station transmits the downlink calibration pilot signal to the terminal, and the terminal transmits the uplink calibration pilot signal to the base station.

Step 506: the terminal measures an RSRP or an RSRQ based on the downlink calibration pilot signal or a CSI-RS or an SSB signal, and reports a measurement result to the base station. The base station measures the uplink calibration pilot signal or the SRS signal.

Step 507: the base station determines whether a signal quality satisfies an auxiliary calibration threshold based on a measurement result reported from the terminal and/or a measurement result of the signal transmitted from the terminal. If it satisfies the auxiliary calibration threshold, the terminal may continue subsequent calibration. Otherwise, the set of auxiliary calibration terminals is updated, and suitable terminals are selected from the corresponding set to continue auxiliary calibration.

It should be noted that the above steps 501-502, 503-504 and 505-506 are not limited to a strict sequence and may be performed in parallel.

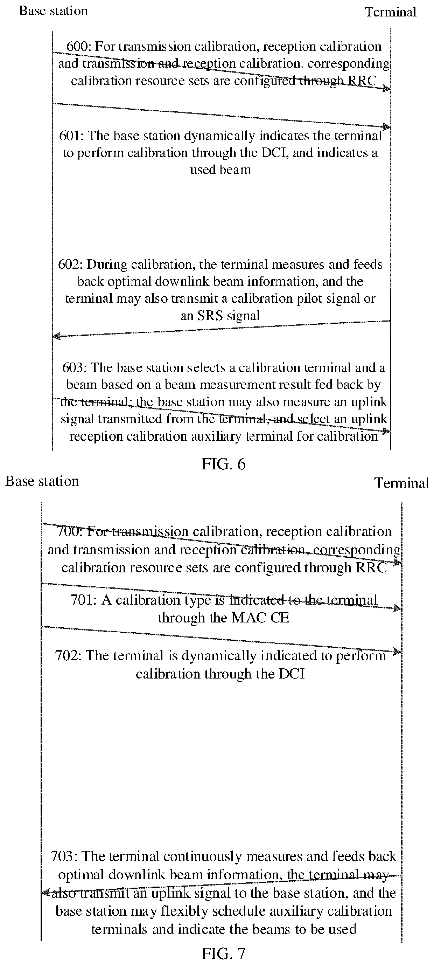

FIG. 6 is a first implementation schematic diagram of a method for calibrating antennas according to an embodiment of the present application. As shown in FIG. 6, the implementation includes the following steps.

Step 600: the base station configures a (downlink) calibration resource set for transmission, an (uplink) calibration resource set for reception, and an (uplink and downlink) calibration resource set for transmission and reception through RRC. Specifically, multiple terminals (downlink) transmit a calibration pilot signal, and (uplink) receives the calibration pilot signal. A frequency domain resource, a transmission timing, the number of occupied symbols, and the number of offset symbols, a subframe interval, the number of the times for performing calibration, and a sequence of transmission calibration and reception calibration, etc. being used may be given explicitly or implicitly, and the calibration pilot signal may occupy all subcarriers in a certain frequency domain.

Step 601: the base station dynamically indicates the terminal to perform calibration through the DCI (as shown in table 1), and indicates used beam information, thereby allowing rapid beam switching to ensure calibration performance.

If it is transmission calibration, the base station transmits a calibration pilot signal, the terminal receives the calibration pilot signal, estimates it, and feeds the estimation result back to the base station. If it is reception calibration, the terminal transmits a calibration pilot signal, and the base station receives the calibration pilot signal and estimates it. If it is transmission and reception calibration, the base station transmits a calibration pilot signal, the terminal receives the calibration pilot signal, estimates it, and feeds an estimation result back to the base station; and when all transmission calibrations are finished, reception calibration is started, the terminal transmits the calibration pilot signal, the base station receives the calibration pilot signal and estimates it.

Step 602: during calibration, the terminal may measure and feed back optimal downlink beam information, such as an RSRP, an RSRQ, a CRI, an SSBRI, etc. measured based on a downlink calibration pilot signal or a CSI-RS or an SSB signal. The terminal may also transmit an uplink calibration pilot signal or an SRS signal to the base station.

Step 603: the base station selects a calibration terminal and a beam based on a beam measurement result fed back by the terminal. The base station may measure an uplink signal transmitted from the terminal, and select an uplink reception calibration auxiliary terminal for calibration.

The obtaining of the optimal beam is divided into two processes: 1) during primary selection of an auxiliary calibration terminal, based on beam management, the terminal measures a beam with an optimal RSRP or RSRQ for the CSI-RS or the SSB signal through beam scanning in transmission and reception directions, or the base station measures a reception beam used when the uplink calibration pilot signal or the SRS signal power or a signal-to-noise ratio is the highest; and 2) during calibration, in addition to measurement performed by the terminal and the base station during primary selection, the terminal may also directly measure a quality of the calibration pilot signal and reports it to the base station along with a calibration estimation result.

For a terminal whose analog beams are not aligned (that is, the RSRP and the RSRQ do not satisfy a condition) or terminals whose calibration and service scheduling overlap or conflict in time and frequency domain resources, the calibration may be dynamically stopped and other suitable terminals may be selected to perform antenna array calibration.

FIG. 7 is a second implementation schematic diagram of a method for calibrating antennas according to an embodiment of the present application. As shown in FIG. 7, the implementation mainly includes the following steps.

Step 700: the base station configures a (downlink) calibration resource set for transmission, an (uplink) calibration resource set for reception, and an (uplink and downlink) calibration resource set for transmission and reception through RRC. Specifically, multiple terminals (downlink) transmit a calibration pilot signal, and (uplink) receives the calibration pilot signal. A frequency domain resource, a transmission timing, the number of occupied symbols, and the number of offset symbols, a subframe interval, the number of the times for performing calibration, and a sequence of transmission calibration and reception calibration, etc. being used may be given explicitly or implicitly, and the calibration pilot signal may occupy all subcarriers in a certain frequency domain.

Step 701: the base station indicates a calibration type to the terminal through the MAC CE (as shown in table 2).

Step 702: the base station dynamically indicates the terminal to perform calibration through the DCI (as shown in table 1).

If it is transmission calibration, the base station transmits a calibration pilot signal, the terminal receives the calibration pilot signal, estimates it, and feeds the estimation result back to the base station. If it is reception calibration, the terminal transmits a calibration pilot signal, and the base station receives the calibration pilot signal and estimates it. If it is transmission and reception calibration, the base station transmits a calibration pilot signal, the terminal receives the calibration pilot signal, estimates it, and feeds an estimation result back to the base station; and when all transmission calibrations are finished, reception calibration is started, the terminal transmits the calibration pilot signal, the base station receives the calibration pilot signal and estimates it.

Step 703: during calibration, the terminal may continuously measure and feed back optimal downlink beam information, such as an RSRP, an RSRQ, a CRI, an SSBRI, etc. measured based on a downlink calibration pilot signal or a CSI-RS or an SSB signal. The terminal may also transmit an uplink calibration pilot signal or an SRS signal to the base station. The base station may flexibly schedule auxiliary calibration terminals and indicate the beams to be used.

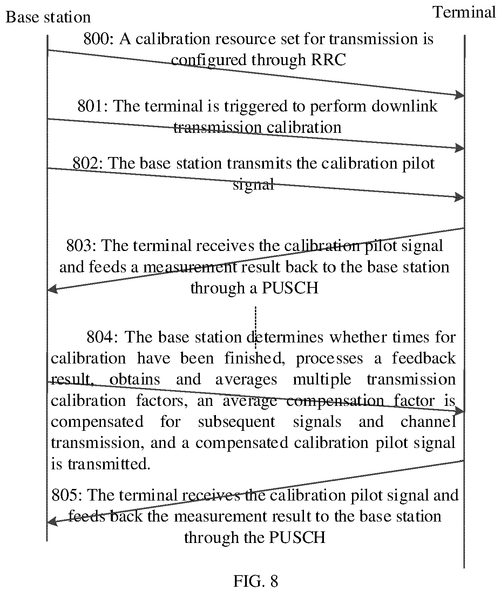

FIG. 8 is a third implementation schematic diagram of a method for calibrating antennas according to an embodiment of the present application. As shown in FIG. 8, the diagram includes the following steps.

Step 800: the base station configures a calibration resource set for transmission through RRC. Specifically, the base station transmits the calibration pilot signal, and a frequency domain resource, a transmission timing, the number of occupied symbols, and the number of offset symbols, a subframe interval, the number of the times for performing calibration, and a sequence of transmission calibration and reception calibration, etc. being used may be given explicitly or implicitly, and the calibration pilot signal may occupy all subcarriers in a certain frequency domain.

Step 801: the base station triggers the terminal to perform downlink transmission calibration through DCI (as shown in table 4).

**Table 4 Calibration command fields and meanings in the DCI**

| Calibration enable | Meaning of command |
|---|---|
| 0 | Start transmission calibration |
| 1 | Start reception calibration |
| 2 | Start transmission-reception calibration or reception-transmission calibration |
| 3 | Stop calibration |

Step 802: the base station transmits the calibration pilot signal.

Step 803: the terminal receives the calibration pilot signal and feeds a measurement result back to the base station through a physical uplink shared channel (PUSCH).

Step 804: the base station determines whether times for calibration have been finished, processes a feedback result, obtains multiple transmission calibration factors, and performs processing to obtain a compensation factor. The compensation factor is compensated for subsequent signals and channel transmission, and a compensated calibration pilot signal is transmitted.

Step 805: the terminal receives the calibration pilot signal and feeds back the measurement result to the base station through the PUSCH.

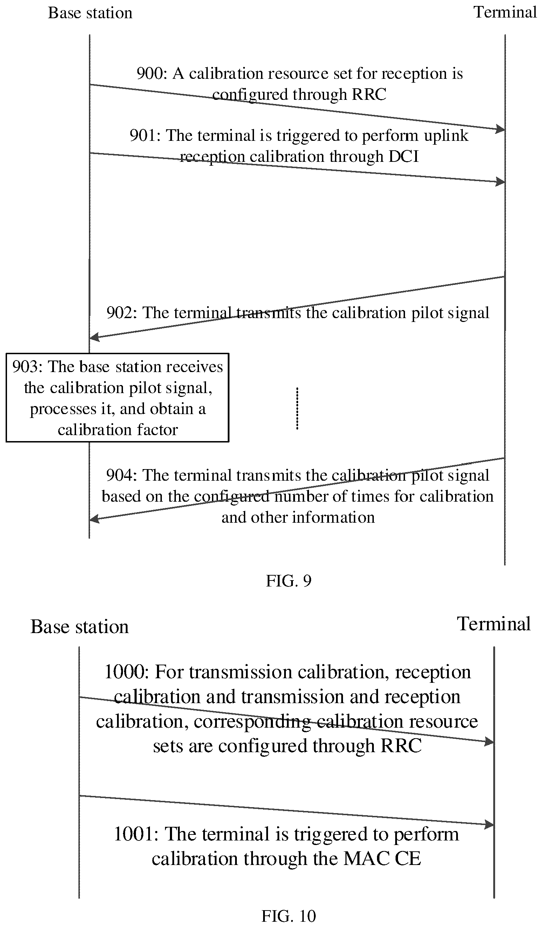

FIG. 9 is a fourth implementation schematic diagram of a method for calibrating antennas according to an embodiment of the present application. As shown in FIG. 9, the implementation mainly includes the following steps.

Step 900: the base station configures a calibration resource set for reception through RRC. Specifically, the base station receives the calibration pilot signal, and a frequency domain resource, a transmission timing, the number of occupied symbols, and the number of offset symbols, a subframe interval, the number of the times for performing calibration, and a sequence of transmission calibration and reception calibration, etc. being used may be given explicitly or implicitly, and the calibration pilot signal may occupy all subcarriers in a certain frequency domain.

Step 901: the base station triggers the terminal to perform uplink reception calibration through the DCI (as shown in table 4).

Step 902: the terminal transmits the calibration pilot signal.

Step 903: the base station receives the calibration pilot signal, performs measurement, and obtain a calibration factor.

Step 904: the terminal transmits the calibration pilot signal based on the configured number of times for calibration and other information, and the base station obtains multiple calibration factors, and performs processing to obtain a compensation factor. The compensation factor is compensated for subsequent signals and channel transmission, and a compensated calibration pilot signal is transmitted.

FIG. 10 is a fifth implementation schematic diagram of a method for calibrating antennas according to an embodiment of the present application. As shown in FIG. 10, the implementation mainly includes the following steps.

Step 1000: the base station configures a (downlink) calibration resource set for transmission, an (uplink) calibration resource set for reception, and an (uplink and downlink) calibration resource set for transmission and reception through RRC. Specifically, multiple terminals (downlink) transmit a calibration pilot signal, and (uplink) receives the calibration pilot signal. A frequency domain resource, a transmission timing, the number of occupied symbols, and the number of offset symbols, a subframe interval, the number of the times for performing calibration, and a sequence of transmission calibration and reception calibration, etc. being used may be given explicitly or implicitly, and the calibration pilot signal may occupy all subcarriers in a certain frequency domain.

Step 1001: the base station triggers the terminal to perform calibration through the MAC CE (as shown in table 3).

If it is transmission calibration, the base station transmits a calibration pilot signal, the terminal receives the calibration pilot signal, estimates it, and feeds the estimation result back to the base station. If it is reception calibration, the terminal transmits a calibration pilot signal, and the base station receives the calibration pilot signal and estimates it. If it is transmission and reception calibration, the base station transmits a calibration pilot signal, the terminal receives the calibration pilot signal, estimates it, and feeds an estimation result back to the base station; and when all transmission calibrations are finished, reception calibration is started, the terminal transmits the calibration pilot signal, the base station receives the calibration pilot signal and estimates it.

The methods and the apparatuses provided in each embodiment of the present application are based on the same conception. Since the methods and the apparatuses solve problems in similar principles, the implementation of the apparatuses and methods may be referred to each other, and similar descriptions will not be repeated.

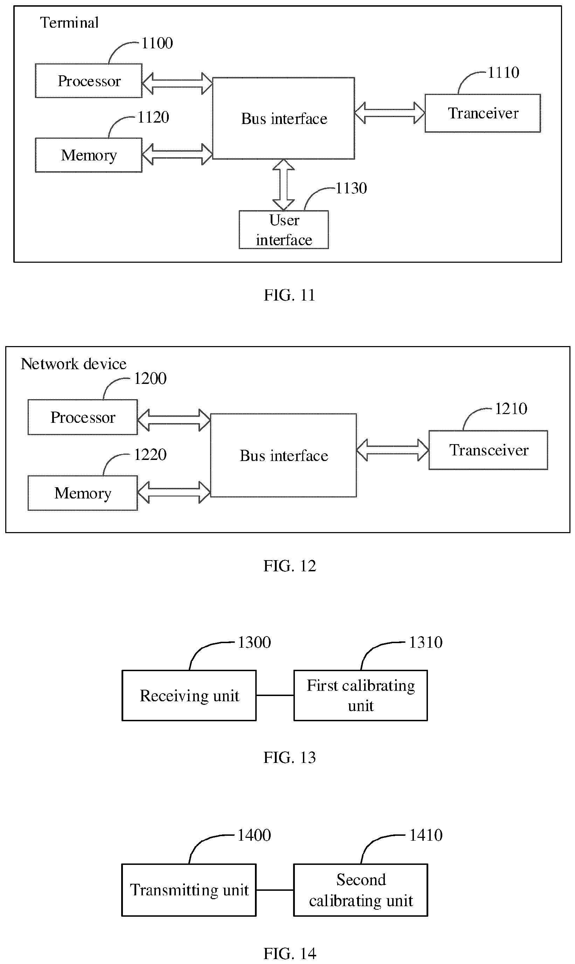

FIG. 11 is a schematic structural diagram of a terminal according to an embodiment of the present application. As shown in FIG. 11, the terminal includes a memory 1120, a transceiver 1110 and a processor 1100. The processor 1100 and the memory 1120 may also be physically arranged separately.

The memory 1120 is used to store a computer program, and the transceiver 1110 is used to transmit and receive data under control of the processor 1100.

In an embodiment, the transceiver 1110 is used for transmitting and receiving data under control of the processor 1100.

In FIG. 11, a bus architecture may include any number of interconnected buses and bridges, which are linked together through various circuits of one or more processors represented by the processor 1100 and one or more memories represented by the memory 1120. The bus architecture may also link together various other circuits, such as peripherals, voltage regulators, and power management circuits, these are well known in the art, and therefore will not be further described in the present application. The bus interface provides an interface. The transceiver 1110 may be multiple elements, i.e., including a transmitter and a receiver, units for providing communication with various other devices over transmission media including wireless channels, wired channels, fiber optic cables, and the like. For different user equipment, a user interface 1130 may be an interface capable of externally or internally connecting the required equipment, and the connected equipment includes, but not limited to, a keypad, a display, a speaker, a microphone, a joystick, and the like.

The processor 1100 is responsible for managing the bus architecture and general processing, and the memory 1120 may store data used by the processor 1100 when performing operations.

The processor 1100 may be a central processing unit (CPU), an application specific integrated circuit (ASIC), a field-programmable gate array (FPGA), or a complex programmable logic device (CPLD), the processor 1100 may also use a multi-core architecture.

The processor 1100 is configured to execute any of the methods applied to the terminal provided by the embodiments of the present application according to the obtained executable instructions by calling the computer program stored in the memory 1120, for example: receiving a calibration resource set transmitted from a network device, where the calibration resource set is used to indicate configuration information associated with the calibration pilot signal; and receiving a downlink calibration pilot signal and/or transmitting an uplink calibration pilot signal based on the calibration resource set, to assist the network device in performing antenna calibration.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the method further includes:
receiving indication information transmitted from the network device, where the indication information is used to indicate the terminal to perform antenna calibration.

In an embodiment, the indication information is first indication information indicating starting or stopping calibration;
receiving the downlink calibration pilot signal and/or transmitting the uplink calibration pilot signal based on the calibration resource set includes:
determining an antenna calibration type based on the calibration resource set; and
receiving the downlink calibration pilot signal and/or transmitting the uplink calibration pilot signal based on the antenna calibration type, the first indication information and the calibration resource set.

In an embodiment, the indication information includes second indication information indicating starting or stopping calibration, and third indication information indicating an antenna calibration type;
receiving the downlink calibration pilot signal and/or transmitting the uplink calibration pilot signal based on the calibration resource set includes:
determining the antenna calibration type based on the third indication information; and
receiving the downlink calibration pilot signal and/or transmitting the uplink calibration pilot signal based on the antenna calibration type, the second indication information and the calibration resource set.

In an embodiment, the indication information is fourth indication information indicating starting or stopping antenna calibration of a specified type;
receiving the downlink calibration pilot signal and/or transmitting the uplink calibration pilot signal based on the calibration resource set includes:
receiving the downlink calibration pilot signal and/or transmitting the uplink calibration pilot signal based on the fourth indication information and the calibration resource set.

In an embodiment, the indication information includes one or more of downlink control information (DCI) or media access control control element (MAC CE).

In an embodiment, the calibration pilot signal occupies all subcarriers in a frequency domain where the calibration pilot signal is located.

FIG. 12 is a schematic structural diagram of a network device according to an embodiment of the present application. As shown in FIG. 12, the network device includes a memory 1220, a transceiver 1210 and a processor 1200. The processor 1200 and the memory 1220 may also be physically arranged separately.

The memory 1220 is used to store computer programs, the transceiver 1210 is used to transmit and receive data under control of the processor 1200.

In an embodiment, the transceiver 1210 is used to receive and transmit data under control of the processor 1200.

In FIG. 12, a bus architecture may include any number of interconnected buses and bridges, which are linked together through various circuits of one or more processors represented by the processor 1210 and one or more memories represented by the memory 1220. The bus architecture may also link together various other circuits, such as peripherals, voltage regulators, and power management circuits, these are well known in the art, and therefore will not be further described in the present application. The bus interface provides an interface. The transceiver 1210 may be multiple elements, i.e., including a transmitter and a receiver, units for providing communication with various other devices over transmission media including wireless channels, wired channels, fiber optic cables, and the like.

The processor 1200 is responsible for managing the bus architecture and general processing, and the memory 1220 may store data used by the processor 1200 when performing operations.

The processor 1200 may be a central processing unit (CPU), an application specific integrated circuit (ASIC), a field-programmable gate array (FPGA), or a complex programmable logic device (CPLD), the processor may also use a multi-core architecture.

The processor 1200 is configured to execute any of the methods applied to the network device provided by the embodiments of the present application according to the obtained executable instructions by calling the computer program stored in the memory 1220, for example: transmitting a calibration resource set to a terminal, where the calibration resource set is used to indicate configuration information associated with a calibration pilot signal; and performing antenna calibration based on an uplink calibration pilot signal transmitted from the terminal and/or a measurement result corresponding to a downlink calibration pilot signal.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the method further includes:
transmitting indication information to the terminal, where the indication information is used to indicate the terminal to perform antenna calibration.

In an embodiment, the indication information is first indication information indicating starting or stopping calibration; or,
the indication information includes second indication information indicating starting or stopping calibration, and third indication information indicating an antenna calibration type; or,
the indication information is fourth indication information indicating starting or stopping antenna calibration of a specified type.

In an embodiment, the indication information includes one or more of downlink control information (DCI) or media access control control element (MAC CE).

In an embodiment, the method further includes:
performing a dynamic update for a set of auxiliary calibration terminals based on a signal measurement result reported from the terminals and/or a measurement result obtained by measuring a signal transmitted from the terminal.

It should be noted here that, the above-mentioned terminal and network device according to the embodiments of the present application may implement all the method steps implemented by the above-mentioned method embodiments, and may achieve the same effect. The same parts and beneficial effects as the same method embodiments are not repeated in the present application.

FIG. 13 is a first schematic structural diagram of an apparatus for calibrating antennas according to an embodiment of the present application. The device may be applied to a terminal. As shown in FIG. 13, the apparatus includes:
a receiving unit 1300, used for receiving a calibration resource set transmitted from the network device, where the calibration resource set is used to indicate configuration information associated with a calibration pilot signal; and
a first calibrating unit 1310, used for receiving a downlink calibration pilot signal and/or transmitting an uplink calibration pilot signal based on the calibration resource set, to assist the network device in performing antenna calibration.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the receiving unit 1300 is further used for:
receiving indication information transmitted from the network device, where the indication information is used to indicate the terminal to perform antenna calibration.

In an embodiment, the indication information is first indication information indicating starting or stopping calibration;
receiving the downlink calibration pilot signal and/or transmitting the uplink calibration pilot signal based on the calibration resource set includes:
determining an antenna calibration type based on the calibration resource set; and
receiving the downlink calibration pilot signal and/or transmitting the uplink calibration pilot signal based on the antenna calibration type, the first indication information and the calibration resource set.

In an embodiment, the indication information includes second indication information indicating starting or stopping calibration, and third indication information indicating an antenna calibration type;
receiving the downlink calibration pilot signal and/or transmitting the uplink calibration pilot signal based on the calibration resource set includes:
determining the antenna calibration type based on the third indication information; and
receiving the downlink calibration pilot signal and/or transmitting the uplink calibration pilot signal based on the antenna calibration type, the second indication information and the calibration resource set.

In an embodiment, the indication information is fourth indication information indicating starting or stopping antenna calibration of a specified type;
receiving the downlink calibration pilot signal and/or transmitting the uplink calibration pilot signal based on the calibration resource set includes:
receiving the downlink calibration pilot signal and/or transmitting the uplink calibration pilot signal based on the fourth indication information and the calibration resource set.

In an embodiment, the indication information includes one or more of downlink control information (DCI) or media access control control element (MAC CE).

In an embodiment, the calibration pilot signal occupies all subcarriers in a frequency domain where the calibration pilot signal is located.

FIG. 14 is a second schematic structural diagram of an apparatus for calibrating antennas according to an embodiment of the present application. The device may be applied to network device. As shown in FIG. 14, the apparatus includes:
a transmitting unit 1400, used for transmitting a calibration resource set to a terminal, where the calibration resource set is used to indicate configuration information associated with a calibration pilot signal; and
a second calibrating unit 1410, used for performing antenna calibration based on an uplink calibration pilot signal transmitted from the terminal and/or a measurement result corresponding to a downlink calibration pilot signal.

In an embodiment, the calibration resource set includes one or more of the following:
a calibration resource set for transmission, where the calibration resource set for transmission is used to indicate configuration information associated with the downlink calibration pilot signal;
a calibration resource set for reception, where the calibration resource set for reception is used to indicate configuration information associated with the uplink calibration pilot signal; or,
a calibration resource set for transmission and reception, where the calibration resource set for transmission and reception is used to indicate configuration information associated with the downlink calibration pilot signal and the uplink calibration pilot signal.

In an embodiment, the configuration information associated with the calibration pilot signal includes one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

In an embodiment, the transmitting unit 1400 is further used for:
transmitting indication information to the terminal, where the indication information is used to indicate the terminal to perform antenna calibration.

In an embodiment, the indication information is first indication information indicating starting or stopping calibration; or,
the indication information includes second indication information indicating starting or stopping calibration, and third indication information indicating an antenna calibration type; or,
the indication information is fourth indication information indicating starting or stopping antenna calibration of a specified type.

In an embodiment, the indication information includes one or more of downlink control information (DCI) or media access control control element (MAC CE).

In an embodiment, the second calibrating unit 1410 is further used for:
performing a dynamic update for a set of auxiliary calibration terminals based on a signal measurement result reported from the terminals and/or a measurement result obtained by measuring a signal transmitted from the terminal.

It should be noted that, the division of units in the embodiments of the present application is schematic, and is only a logical function division, and there may be other division manners in actual implementation. In addition, the functional units in the various embodiments of the present application may be integrated into one processing unit, or each unit may exist alone physically, or two or more units may be integrated into one unit. The above-mentioned integrated unit may be implemented in the form of hardware or software functional unit.

If the integrated unit is implemented in the form of a software functional unit and sold or used as an independent product, it may be stored in a processor readable storage medium. Based on such understanding, the solutions of the present application in essence or a part of the technical solutions that contributes to the related art, or all or part of the technical solutions, may be embodied in the form of a software product, which is stored in a storage medium, including several instructions to cause a computer device (which may be a personal computer, server, or network device, etc.) or a processor to perform all or part of the steps of the methods described in the respective embodiments of the present application. The storage medium described above includes various media that may store program codes such as U disk, mobile hard disk, read-only memory (ROM), random access memory (RAM), magnetic disk, or optical disk.

It should be noted here that, the above-mentioned apparatuses according to the embodiments of the present application may implement all the method steps implemented by the above-mentioned method embodiments, and may achieve the same effect. The same parts and beneficial effects as the same method embodiments are not repeated in the present application.

An embodiment of the present application further provides a computer-readable storage medium storing a computer program, where the computer program is used to cause a computer to perform the steps of the method for calibrating the antenna provided by the above embodiments, including: receiving a calibration resource set transmitted from a network device, where the calibration resource set is used to indicate configuration information associated with a calibration pilot signal; and receiving a downlink calibration pilot signal and/or transmitting an uplink calibration pilot signal based on the calibration resource set, to assist the network device in performing antenna calibration.

An embodiment of the present application further provides a computer-readable storage medium storing a computer program, where the computer program is used to cause a computer to perform the steps of the method for calibrating the antenna provided by the above embodiments, including: transmitting a calibration resource set to a terminal, where the calibration resource set is used to indicate configuration information associated with a calibration pilot signal; and performing antenna calibration based on an uplink calibration pilot signal transmitted from the terminal and/or a measurement result corresponding to a downlink calibration pilot signal.

The processor-readable storage medium may be any available medium or data storage device that may be accessed by the processor, including but not limited to, a magnetic storage (e.g., a floppy disk, a hard disk, a magnetic tape, a magneto-optical disk (MO), etc.), optical memory (such as CD, DVD, BD, HVD, etc.), and a semiconductor memory (such as ROM, EPROM, EEPROM, non-volatile memory (NAND FLASH), solid-state drive (SSD)), etc.

The solutions according to the embodiments of the present application may be applicable to various systems, especially 5G systems. For example, applicable systems may be a global system of mobile communication (GSM) system, a code division multiple access (CDMA) system, a wideband code division multiple access (WCDMA) general packet radio service (GPRS) system, a long term evolution (LTE) system, an LTE frequency division duplex (FDD) system, an LTE time division duplex (TDD) system, a long term evolution advanced (LTE-A) system, a universal mobile telecommunication system (UMTS), a worldwide interoperability for microwave access (WiMAX) system, a 5G new radio (NR) system, etc. These various systems include user equipment and a network device. The system may also include a core network part, such as an evolved packet system (EPS), a 5G system (5GS), and the like.

The terminal in the embodiments of the present application may be a device that provides voice and/or data connectivity to a user, a handheld device with a radio connection function, or other processing device connected to a radio modem. In different systems, the names of the terminal may be different. For example, in the 5G system, the terminal may be called as user equipment (UE). A radio terminal may communicate with one or more core networks (CN) via a radio access network (RAN), and the radio terminal may be a mobile terminal, such as a mobile phone (or cellular phone) and computers with mobile terminal, e.g., a portable mobile device, a pocket-sized mobile device, a hand-held mobile device, a computer-built mobile device or a vehicle-mounted mobile device, which exchange language and/or data with the radio access network. For example, a personal communication service (PCS) phone, a radio phone, a session initiated protocol (SIP) phone, a wireless local loop (WLL) station, a personal digital assistant (PDA) and other devices. A radio terminal may also be called a system, a subscriber unit, a subscriber station, a mobile station, a mobile, a remote station, an access point, a remote terminal, an access terminal, a user terminal, a user agent, and a user device, which are not limited in the embodiments of the present application.

The network device in the embodiments of the present application may be a base station, and the base station may include multiple cells providing services for the terminal. Depending on the specific application, the network device may also be called an access point, or may be a device in the access network that communicates with radio terminal through one or more sectors on the air interface, or other names. Network device may be used to exchange received air frames with internet protocol (IP) packets, and act as a router between radio terminal and the rest of the access network, and the rest of the access network may include an IP communication network. The network device may also coordinate attribute management for the air interface. For example, the network device in the embodiments of the present application may be a base transceiver station (BTS) in a global system for mobile communications (GSM) or a code division multiple access (CDMA), may also be a node B in a wide-band code division multiple access (WCDMA), may also be an evolutional node B (eNB or e-Node B) in a long term evolution (LTE) system, a 5G base station (gNB) in 5G network architecture (next generation system), may also be a Home evolved Node B (HeNB), a relay node (relay node), a femto base station (femto), a pico base station (pico), etc., which are not limited in the embodiments of the present application. In some network structures, a network device may include a centralized unit (CU) node and a distributed unit (DU) node, and the centralized unit and the distributed unit may also be geographically separated.

Multi-input multi-output (MIMO) transmission may be performed between the network device and the terminal using one or more antennas and the MIMO transmission may be single user MIMO (SU-MIMO) or multiple user MIMO (MU-MIMO). According to the form and number of antenna combinations, MIMO transmission may be 2D-MIMO, 3D-MIMO, FD-MIMO, or massive-MIMO, and may also be diversity transmission, precoding transmission, or beamforming transmission.

As will be appreciated by those skilled in the art, embodiments of the present application may be provided as a method, system, or computer program product. Accordingly, the present application may take the form of an entirely hardware embodiment, an entirely software embodiment, or an embodiment combining software and hardware aspects. Furthermore, the present application may take the form of a computer program product embodied on one or more computer-usable storage media having computer-usable program code embodied therein, including but not limited to disk storage, optical storage, and the like.

The present application is described with reference to flow charts and/or block diagrams of methods, apparatus (systems), and computer program products according to embodiments of the present application. It will be understood that each flow and/or block in the flow charts and/or block diagrams, and combinations thereof may be implemented by computer-executable instructions. These computer-executable instructions may be provided to processors of a general purpose computer, a special purpose computer, an embedded processor or other programmable data processing device to produce a machine and the instructions executed by the processor of the computer or other programmable data processing device form a means for performing the functions specified in one or more flows in a flowchart and/or one or more blocks of a block diagram.

These processor-executable instructions may also be stored in a processor-readable memory capable of directing a computer or other programmable data processing apparatus to operate in a particular manner, and the instructions stored in the processor-readable memory may result in a manufacture including instruction means, the instruction means may perform the functions specified in one or more flows of the flowchart and/or one or more blocks of the block diagram.

These processor-executable instructions may also be loaded onto a computer or other programmable data processing device to cause a series of operational steps to be performed on the computer or other programmable device to produce a computer-implemented process and instructions performed on the computer or other programmable devices provide steps for performing the functions specified in one or more flows of the flowchart and/or one or more blocks of the block diagram.

It will be apparent to those skilled in the art that various modifications and variations may be made to the present application without departing from the scope of the present application. Thus, provided that these modifications and variations of the present application fall within the scope of the claims of the present application and their equivalents, the present application is also intended to cover such modifications and variations.

## Claims

1. A method for calibrating antennas, applied to a terminal, comprising:
receiving a calibration resource set transmitted from a network device, wherein the calibration resource set is used to indicate configuration information associated with a calibration pilot signal; and
receiving a downlink calibration pilot signal and/or transmitting an uplink calibration pilot signal based on the calibration resource set, to assist the network device in performing antenna calibration.

2. The method of claim 1, wherein the calibration resource set comprises one or more of the following:
a calibration resource set for transmission, wherein the calibration resource set for transmission is used to indicate configuration information associated with the downlink calibration pilot signal;
a calibration resource set for reception, wherein the calibration resource set for reception is used to indicate configuration information associated with the uplink calibration pilot signal; or,
a calibration resource set for transmission and reception, wherein the calibration resource set for transmission and reception is used to indicate configuration information associated with the downlink calibration pilot signal and the uplink calibration pilot signal.

3. The method of claim 2, wherein the configuration information associated with the calibration pilot signal comprises one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

4. The method of claim 1, further comprising:
receiving indication information transmitted from the network device, wherein the indication information is used to indicate the terminal to perform antenna calibration.

5. The method of claim 4, wherein the indication information is first indication information indicating starting or stopping calibration;
receiving the downlink calibration pilot signal and/or transmitting the uplink calibration pilot signal based on the calibration resource set comprises:
determining an antenna calibration type based on the calibration resource set; and
receiving the downlink calibration pilot signal and/or transmitting the uplink calibration pilot signal based on the antenna calibration type, the first indication information and the calibration resource set.

6. The method of claim 4, wherein the indication information comprises second indication information indicating starting or stopping calibration, and third indication information indicating an antenna calibration type;
receiving the downlink calibration pilot signal and/or transmitting the uplink calibration pilot signal based on the calibration resource set comprises:
determining the antenna calibration type based on the third indication information; and
receiving the downlink calibration pilot signal and/or transmitting the uplink calibration pilot signal based on the antenna calibration type, the second indication information and the calibration resource set.

7. The method of claim 4, wherein the indication information is fourth indication information indicating starting or stopping antenna calibration of a specified type;
receiving the downlink calibration pilot signal and/or transmitting the uplink calibration pilot signal based on the calibration resource set comprises:
receiving the downlink calibration pilot signal and/or transmitting the uplink calibration pilot signal based on the fourth indication information and the calibration resource set.

8. The method of any one of claims 4 to 7, wherein the indication information comprises one or more of downlink control information, DCI, or media access control control element, MAC CE.

9. The method of any one of claims 1 to 7, wherein the calibration pilot signal occupies all subcarriers in a frequency domain wherein the calibration pilot signal is located.

10. A method for calibrating antennas, applied to a network device, comprising:
transmitting a calibration resource set to a terminal, wherein the calibration resource set is used to indicate configuration information associated with a calibration pilot signal; and
performing antenna calibration based on an uplink calibration pilot signal transmitted from the terminal and/or a measurement result corresponding to a downlink calibration pilot signal.

11. The method of claim 10, wherein the calibration resource set comprises one or more of the following:
a calibration resource set for transmission, wherein the calibration resource set for transmission is used to indicate configuration information associated with the downlink calibration pilot signal;
a calibration resource set for reception, wherein the calibration resource set for reception is used to indicate configuration information associated with the uplink calibration pilot signal; or,
a calibration resource set for transmission and reception, wherein the calibration resource set for transmission and reception is used to indicate configuration information associated with the downlink calibration pilot signal and the uplink calibration pilot signal.

12. The method of claim 11, wherein the configuration information associated with the calibration pilot signal comprises one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

13. The method of claim 10, further comprising:
transmitting indication information to the terminal, wherein the indication information is used to indicate the terminal to perform antenna calibration.

14. The method of claim 13, wherein the indication information is first indication information indicating starting or stopping calibration; or,
the indication information comprises second indication information indicating starting or stopping calibration, and third indication information indicating an antenna calibration type; or,
the indication information is fourth indication information indicating starting or stopping antenna calibration of a specified type.

15. The method of claim 14, wherein the indication information comprises one or more of downlink control information, DCI, or media access control control element, MAC CE.

16. The method of claim 10, further comprising:
performing a dynamic update for a set of auxiliary calibration terminals based on a signal measurement result reported from the terminals and/or a measurement result obtained by measuring a signal transmitted from the terminal.

17. A terminal, comprising a memory, a transceiver and a processor,
wherein the memory is used to store a computer program, the transceiver is used to transmit and receive data under control of the processor, and the processor is used to read the computer program in the memory and perform the following operations of:
receiving a calibration resource set transmitted from a network device, wherein the calibration resource set is used to indicate configuration information associated with a calibration pilot signal; and
receiving a downlink calibration pilot signal and/or transmitting an uplink calibration pilot signal based on the calibration resource set, to assist the network device in performing antenna calibration.

18. The terminal of claim 17, wherein the calibration resource set comprises one or more of the following:
a calibration resource set for transmission, wherein the calibration resource set for transmission is used to indicate configuration information associated with the downlink calibration pilot signal;
a calibration resource set for reception, wherein the calibration resource set for reception is used to indicate configuration information associated with the uplink calibration pilot signal; or,
a calibration resource set for transmission and reception, wherein the calibration resource set for transmission and reception is used to indicate configuration information associated with the downlink calibration pilot signal and the uplink calibration pilot signal.

19. The terminal of claim 18, wherein the configuration information associated with the calibration pilot signal comprises one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

20. The terminal of claim 17, wherein the operations further comprise:
receiving indication information transmitted from the network device, wherein the indication information is used to indicate the terminal to perform antenna calibration.

21. The terminal of claim 20, wherein the indication information is first indication information indicating starting or stopping calibration;
receiving the downlink calibration pilot signal and/or transmitting the uplink calibration pilot signal based on the calibration resource set comprises:
determining an antenna calibration type based on the calibration resource set; and
receiving the downlink calibration pilot signal and/or transmitting the uplink calibration pilot signal based on the antenna calibration type, the first indication information and the calibration resource set.

22. The terminal of claim 20, wherein the indication information comprises second indication information indicating starting or stopping calibration, and third indication information indicating an antenna calibration type;
receiving the downlink calibration pilot signal and/or transmitting the uplink calibration pilot signal based on the calibration resource set comprises:
determining the antenna calibration type based on the third indication information; and
receiving the downlink calibration pilot signal and/or transmitting the uplink calibration pilot signal based on the antenna calibration type, the second indication information and the calibration resource set.

23. The terminal of claim 20, wherein the indication information is fourth indication information indicating starting or stopping antenna calibration of a specified type;
receiving the downlink calibration pilot signal and/or transmitting the uplink calibration pilot signal based on the calibration resource set comprises:
receiving the downlink calibration pilot signal and/or transmitting the uplink calibration pilot signal based on the fourth indication information and the calibration resource set.

24. The terminal of any one of claims 20 to 23, wherein the indication information comprises one or more of downlink control information, DCI, or media access control control element, MAC CE.

25. The terminal of any one of claims 17 to 23, wherein the calibration pilot signal occupies all subcarriers in a frequency domain wherein the calibration pilot signal is located.

26. A network device, comprising a memory, a transceiver and a processor,
wherein the memory is used to store a computer program, the transceiver is used to transmit and receive data under control of the processor, and the processor is used to read the computer program in the memory and perform the following operation of:
transmitting a calibration resource set to a terminal, wherein the calibration resource set is used to indicate configuration information associated with a calibration pilot signal; and
performing antenna calibration based on an uplink calibration pilot signal transmitted from the terminal and/or a measurement result corresponding to a downlink calibration pilot signal.

27. The network device of claim 26, wherein the calibration resource set comprises one or more of the following:
a calibration resource set for transmission, wherein the calibration resource set for transmission is used to indicate configuration information associated with the downlink calibration pilot signal;
a calibration resource set for reception, wherein the calibration resource set for reception is used to indicate configuration information associated with the uplink calibration pilot signal; or,
a calibration resource set for transmission and reception, wherein the calibration resource set for transmission and reception is used to indicate configuration information associated with the downlink calibration pilot signal and the uplink calibration pilot signal.

28. The network device of claim 27, wherein the configuration information associated with the calibration pilot signal comprises one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

29. The network device of claim 26, wherein the operations further comprise:
transmitting indication information to the terminal, wherein the indication information is used to indicate the terminal to perform antenna calibration.

30. The network device of claim 29, wherein the indication information is first indication information indicating starting or stopping calibration; or,
the indication information comprises second indication information indicating starting or stopping calibration, and third indication information indicating an antenna calibration type; or,
the indication information is fourth indication information indicating starting or stopping antenna calibration of a specified type.

31. The network device of claim 30, wherein the indication information comprises one or more of downlink control information, DCI, or media access control control element, MAC CE.

32. The network device of claim 26, wherein the operations further comprise:
performing a dynamic update for a set of auxiliary calibration terminals based on a signal measurement result reported from the terminals and/or a measurement result obtained by measuring a signal transmitted from the terminal.

33. An apparatus for calibrating antennas, applied to a terminal, comprising:
a receiving unit, used for receiving a calibration resource set transmitted from a network device, wherein the calibration resource set is used to indicate configuration information associated with a calibration pilot signal; and
a first calibrating unit, used for receiving a downlink calibration pilot signal and/or transmitting an uplink calibration pilot signal based on the calibration resource set, to assist the network device in performing antenna calibration.

34. The apparatus of claim 33, wherein the calibration resource set comprises one or more of the following:
a calibration resource set for transmission, wherein the calibration resource set for transmission is used to indicate configuration information associated with the downlink calibration pilot signal;
a calibration resource set for reception, wherein the calibration resource set for reception is used to indicate configuration information associated with the uplink calibration pilot signal; or,
a calibration resource set for transmission and reception, wherein the calibration resource set for transmission and reception is used to indicate configuration information associated with the downlink calibration pilot signal and the uplink calibration pilot signal.

35. The apparatus of claim 34, wherein the configuration information associated with the calibration pilot signal comprises one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

36. The apparatus of claim 33, wherein the receiving unit is further used for:
receiving indication information transmitted from the network device, wherein the indication information is used to indicate the terminal to perform antenna calibration.

37. The apparatus of claim 36, wherein the indication information is first indication information indicating starting or stopping calibration;
receiving the downlink calibration pilot signal and/or transmitting the uplink calibration pilot signal based on the calibration resource set comprises:
determining an antenna calibration type based on the calibration resource set; and
receiving the downlink calibration pilot signal and/or transmitting the uplink calibration pilot signal based on the antenna calibration type, the first indication information and the calibration resource set.

38. The apparatus of claim 36, wherein the indication information comprises second indication information indicating starting or stopping calibration, and third indication information indicating an antenna calibration type;
receiving the downlink calibration pilot signal and/or transmitting the uplink calibration pilot signal based on the calibration resource set comprises:
determining the antenna calibration type based on the third indication information; and
receiving the downlink calibration pilot signal and/or transmitting the uplink calibration pilot signal based on the antenna calibration type, the second indication information and the calibration resource set.

39. The apparatus of claim 36, wherein the indication information is fourth indication information indicating starting or stopping antenna calibration of a specified type;
receiving the downlink calibration pilot signal and/or transmitting the uplink calibration pilot signal based on the calibration resource set comprises:
receiving the downlink calibration pilot signal and/or transmitting the uplink calibration pilot signal based on the fourth indication information and the calibration resource set.

40. The apparatus of any one of claims 36 to 39, wherein the indication information comprises one or more of downlink control information, DCI, or media access control control element, MAC CE.

41. The apparatus of any one of claims 33 to 39, wherein the calibration pilot signal occupies all subcarriers in a frequency domain wherein the calibration pilot signal is located.

42. An apparatus for calibrating antennas, applied to a network device, comprising:
a transmitting unit, used for transmitting a calibration resource set to a terminal, wherein the calibration resource set is used to indicate configuration information associated with a calibration pilot signal; and
a second calibrating unit, used for performing antenna calibration based on an uplink calibration pilot signal transmitted from the terminal and/or a measurement result corresponding to a downlink calibration pilot signal.

43. The apparatus of claim 42, wherein the calibration resource set comprises one or more of the following:
a calibration resource set for transmission, wherein the calibration resource set for transmission is used to indicate configuration information associated with the downlink calibration pilot signal;
a calibration resource set for reception, wherein the calibration resource set for reception is used to indicate configuration information associated with the uplink calibration pilot signal; or,
a calibration resource set for transmission and reception, wherein the calibration resource set for transmission and reception is used to indicate configuration information associated with the downlink calibration pilot signal and the uplink calibration pilot signal.

44. The apparatus of claim 43, wherein the configuration information associated with the calibration pilot signal comprises one or more of the following:
a type of the calibration pilot signal;
a frequency domain resource occupied by the calibration pilot signal;
a timing for transmitting the calibration pilot signal;
the number of symbols occupied by the calibration pilot signal;
the number of offset symbols corresponding to the calibration pilot signal;
a period for transmitting the calibration pilot signal;
a subframe interval for transmitting the calibration pilot signal;
the number of times for transmitting the calibration pilot signal; or,
a sequence of transmission calibration and reception calibration.

45. The apparatus of claim 42, wherein the transmitting unit is further used for:
transmitting indication information to the terminal, wherein the indication information is used to indicate the terminal to perform antenna calibration.

46. The apparatus of claim 45, wherein the indication information is first indication information indicating starting or stopping calibration; or,
the indication information comprises second indication information indicating starting or stopping calibration, and third indication information indicating an antenna calibration type; or,
the indication information is fourth indication information indicating starting or stopping antenna calibration of a specified type.

47. The apparatus of claim 46, wherein the indication information comprises one or more of downlink control information, DCI, or media access control control element, MAC CE.

48. The apparatus of claim 42, wherein the second calibrating unit is further used for:
performing a dynamic update for a set of auxiliary calibration terminals based on a signal measurement result reported from the terminals and/or a measurement result obtained by measuring a signal transmitted from the terminal.

49. A computer-readable storage medium storing a computer program, wherein the computer program is used to cause a computer to perform the steps of the method of any one of claims 1 to 9, or perform the steps of the method of any one of claims 10 to 16.
